Europäisches Patentamt

European Patent Office

Office européen des brevets

(19)

(11) Veröffentlichungsnummer : **0 610 184 B1**

(12) **EUROPÄISCHE PATENTSCHRIFT**

(45) Veröffentlichungstag der Patentschrift :
**03.05.95 Patentblatt 95/18**

(51) Int. Cl.⁶ : **G03F 7/20**

(21) Anmeldenummer : **91919413.4**

(22) Anmeldetag : **30.10.91**

(86) Internationale Anmeldenummer :
**PCT/DE91/00860**

(87) Internationale Veröffentlichungsnummer :
**WO 93/09472 13.05.93 Gazette 93/12**

(54) **BELICHTUNGSVORRICHTUNG.**

(43) Veröffentlichungstag der Anmeldung :
**17.08.94 Patentblatt 94/33**

(45) Bekanntmachung des Hinweises auf die
Patenterteilung :
**03.05.95 Patentblatt 95/18**

(84) Benannte Vertragsstaaten :
**AT CH DE FR LI NL SE**

(56) Entgegenhaltungen :
**US-A- 4 675 702**
**US-A- 4 728 185**
**PROCEEDINGS OF SPIE Bd. 1018, 1988, BEL-**
**LINGHAM, WA, US Seiten 79 - 85; W.BRINKER**
**ET AL.: 'Deformation behaviour of thin viscoe-**
**lastic layers used in an active-matrix-adres-**
**sed spatial light modulator' in der Anmeldung**
**erwähnt**
**Firmenschrift Texas Instrument, JMF**
**008:0260; 10/87, "The deformable mirror devi-**
**ce"**

(73) Patentinhaber :
**FRAUNHOFER-GESELLSCHAFT ZUR**
**FÖRDERUNG DER ANGEWANDTEN**
**FORSCHUNG E.V.**
**Leonrodstrasse 54**
**D-80636 München (DE)**

(72) Erfinder : **VOGT, Holger**
**Rotdornbogen 28**
**D-45481 Mühlheim (DE)**
Erfinder : **KÜCK, Heinz**
**Lindauer Strasse 28**
**D-47249 Duisburg (DE)**
Erfinder : **HESS, Günther**
**Richard-Wagner-Strasse 112**
**D-47057 Duisburg (DE)**
Erfinder : **GEHNER, Andreas**
**Kammerstrasse 89**
**D-47057 Duisburg (DE)**

(74) Vertreter : **Schoppe, Fritz, Dipl.-Ing. et al**
**Patentanwalt,**
**Georg-Kalb-Strasse 9**
**D-82049 Pullach (DE)**

EP 0 610 184 B1

## Beschreibung

Die vorliegende Erfindung betrifft eine Belichtungsvorrichtung zum Herstellen von Vorlagen, wie beispielsweise Retikels und Masken, für die Fertigung elektronischer Elemente oder zum Direktbelichten von Scheiben und Substraten bei den für die Herstellung notwendigen fotolithographischen Schritten oder von Strukturen mit lichtempfindlichen Schichten, wobei diese Belichtungsvorrichtung eine Lichtquelle und einen Mustergenerator umfaßt.

Insbesondere befaßt sich die vorliegende Erfindung mit der Herstellung von Vorlagen, Retikels und Masken oder mit der Direktbelichtung im Mikrometerbereich bei der Halbleiterfertigung, der Fertigung von integrierten Schaltkreisen, der Hybridfertigung und der Fertigung von flachen Bildschirmen sowie ähnlichen Fertigungsverfahren, bei denen Belichtungsprozesse eingesetzt werden. Insbesondere befaßt sich die Erfindung mit einer Belichtungsvorrichtung, wie sie für die Direktbelichtung von Halbleiterscheiben in der Halbleiterfertigung und von Substraten in der Hybrid- und Verbindungstechnik eingesetzt werden kann.

Bei der Herstellung von Retikels, die Belichtungsschablonen für die fotolithographische Schaltkreisherstellung sind, sowie bei der Herstellung von Masken und bei der Direktbelichtung von Halbleiterprodukten werden Elektronenstrahlschreiber, Laserstrahlgeräte und optische Mustergeneratoren mit einer Laserlichtquelle oder einer Quecksilberdampflampe eingesetzt. Optische Mustergeneratoren nach dem Stand der Technik erzeugen die gewünschten Strukturen durch das aufeinanderfolgende, einzelne Belichten von Rechteckfenstern, die durch mechanische Rechteckblenden festgelegt werden. Die Komplexität der zu erzeugenden Struktur bestimmt die Anzahl der erforderlichen Belichtungsrechtecke, die wiederum die Schreibzeit oder Belichtungszeit für die Struktur bestimmt. Die Genauigkeit der verwendeten mechanischen Rechteckblenden begrenzt wiederum die Genauigkeit der mit diesen bekannten Mustergeneratoren erzeugbaren Strukturen.

Bei Laserstrahlgeräten nach dem Stand der Technik wird die zu belichtende Fläche mit einem Laserstrahl abgerastert. Die Schreibgeschwindigkeit oder Belichtungsgeschwindigkeit derartiger Laserstrahlgeräte ist durch den für das Rasterverfahren notwendigen seriellen Datenfluß begrenzt. Ferner bedingen derartige Laserstrahlgeräte einen hohen mechanischoptischen Aufwand.

Die im Stand der Technik eingesetzten Elektronenstrahlgeräte können nur für die Belichtung von elektronenempfindlichen, speziellen Photolacksystemen verwendet werden und erfordern, verglichen mit den oben beschriebenen Laserstrahlgeräten, zusätzlich eine Hochvakuumtechnik. Elektronenstrahlgeräte erfordern daher sehr hohe Investitions- und Betriebskosten.

Aus der Fachveröffentlichung W. Brinker et al, "Deformation behavior of thin viscoelastic layers used in an active -matrix-addressed spatial light modulator", Proceedings of SPIE 1989, Band 1018, (1988), Seiten 79-85, ist es bereits bekannt, für die Erzeugung von Fernsehbildern oder für Zwecke der Bildanzeige ein reflektives optisches Schlieren-System mit einem aktiven, Matrix-adressierten, viskoelastischen Flächenlichtmodulator einzusetzen. Dieser umfaßt eine Dauerlichtquelle, deren Licht durch ein geeignetes optisches System vertikal auf die Oberfläche des Flächenlichtmodulators auffällt. Oberflächenbereiche des Flächenlichtmodulators sind bei Adressierung von Steuerelektroden deformierbar, so daß das auf die Oberfläche fallende Licht bei adressierten Oberflächenelementen gebeugt, bei nicht-adressierten Oberflächenelementen ungebeugt reflektiert wird. Das ungebeugte Licht wird zur Lichtquelle zurückgelenkt, während das gebeugte Licht über das optische Schlierensystem zur Bilderzeugung auf dem Fernsehbildschirm oder auf einer Bildanzeigefläche verwendet wird.

Aus der Firmenschrift Texas Instruments, JMF 008:0260; 10/87, "The deformable mirror device", ist ein Flächenlichtmodulator bekannt, dessen reflektierende Oberfläche aus einer Vielzahl von elektrisch adressierbaren, mechanisch verformbaren Zungen besteht.

Die ältere, nicht vorveröffentlichte internationale Patentanmeldung PCT/DE91/00375 (WO-A- 91/17 483) der Anmelderin offenbart eine Belichtungsvorrichtung zum Herstellen von Vorlagen für die Fertigung elektronischer Elemente oder zum Direktbelichten von Scheiben oder Substraten mit einer Lichtquelle und einem Mustergenerator, bei der der Mustergenerator ein optisches Schlierensystem und einen aktiven, Matrix-adressierbaren Lichtmodulator aufweist, der eine reflektierende Oberfläche hat, deren adressierte Oberflächenbereiche einfallendes Licht beugen und deren nicht-adressierte Oberflächenbereiche einfallendes Licht reflektieren, wobei das Schlierensystem ein Schlierenobjektiv nahe des Flächenlichtmodulators und ein Projektionsobjektiv hat, wobei eine Filtervorrichtung zwischen dem Schlierenobjektiv und dem Projektionsobjektiv angeordnet ist, die das Licht von nicht-adressierten Oberflächenbereichen herausfiltert und lediglich das gebeugte Licht von adressierten Oberflächenbereichen des Flächenlichtmodulators über das Projektionsobjektiv zu der Vorlage bzw. dem elektronischen Element vorläßt. Diese Belichtungsvorrichtung arbeitet in einem sogenannten positiven Mode, bei dem die angesteuerten, adressierten Bereiche des Flächenlichtmodulators belichteten Bereichen in der Projektion auf der Vorlage bzw. dem elektronischen Element entsprechen. Mit anderen Worten läßt die Filtervorrichtung dieser Belichtungsvorrichtung alle Beugungsordnungen mit Ausnahme der nullten Ordnung durch. Die Intensitätsverteilung der Projektion weist eine unerwünschte Modulation auf, deren Amplitude und Modulationsperiode von der Anzahl und Art der zur Projektion beitragenden Beugungsordnungen sowie von dem relativen Einfluß der einzelnen Ordnungen abhängt, wobei der Intensitätsanteil einer Beugungsordnung proportional zum Quadrat der entsprechenden Besselfunktion ist. Die Periode der Feinstruktur der Projektion muß daher soweit reduziert werden, daß sie von der abbildenden Optik bzw. von dem zu belichtenden Fotolack nicht mehr aufgelöst wird. Hierzu kann beispielsweise die Gitterkonstante des Flächenlichtmodulators minimiert, der Projektionsmaßstab verkleinert oder der sogenannte Beugungsefficiency erhöht werden, wodurch der Einfluß höherer Beugungsordnungen erhöht wird. Da für die Erhöhung des Beugungsefficiency eine Erhöhung der Deformationsamplidute erforderlich ist, geht dies mit einer vergrößerten Gitterkonstante einher, so daß der gewünschte Effekt zum Teil wieder kompensiert wird. Daher ist der Grad der erzielbaren Homogenität der Ausleuchtung der einzelnen Bildelemente der Projektion bei dieser Belichtungsvorrichtung begrenzt.

Die US-A-4,675,702 zeigt eine Flächenbelichtungsvorrichtung, die beispielsweise zur Belichtung von photoempfindlichen Filmen einsetzbar ist und als sog. "Photoplotter" ausgeführt sein kann. Diese Belichtungsvorrichtung umfaßt eine Lichtquelle zum Erzeugen eines im wesentlichen parallelen Lichtbündels, welches durch ein ansteuerbares Lichtmatrixventil fällt, das z.B. durch eine Flüssigkristallschicht gebildet sein kann, wodurch nicht zu belichtende Bereiche des photoempfindlichen Filmes definiert werden.

Die US-A-4,728,185 befaßt sich mit einem Schlieren-Abbildungssystem, welches mit Lichtmodulatoren bei einem optischen Printer eingesetzt werden kann. Die Lichtventile selbst können als elektronisch adressierbare Flächenlichtventile ausgeführt sein. Bei dem in dieser Schrift gezeigten Lichtventil handelt es sich um ein balkenförmiges, nicht jedoch um ein flächenartiges Lichtventil. Ferner ist die bekannte Belichtungsvorrichtung derart angeordnet, daß nur diejenigen Teile des balkenförmigen Lichtmodulators, die adressiert sind, auf einer photoempfindlichen Schicht abgebildet werden.

Gegenüber diesem Stand der Technik liegt der vorliegenden Erfindung die Aufgabe zugrunde, eine Belichtungsvorrichtung der eingangs genannten Art zu schaffen, die trotz einfacher Struktur nicht nur eine gegenüber der Belichtungszeit oder Schreibzeit von Laserstrahlanlagen oder Elektronenstrahlanlagen reduzierte Belichtungszeit ermöglicht, sondern auch eine homogene Belichtung der einzelnen Bildelemente der Projektion gewährleistet.

Diese Aufgabe wird durch eine Belichtungsvorrichtung gemäß Patentanspruch 1 gelöst.

Gemäß der Erfindung umfaßt die Belichtungsvorrichtung zum Herstellen von Vorlagen für die Fertigung elektronischer Elemente oder zum Direktbelichten von Scheiben oder Substraten bei den für ihre Herstellung notwendigen fotolithographischen Schritten oder von Strukturen mit lichtempfindlichen Schichten -eine Lichtquelle und einen Mustergenerator, wobei der Mustergenerator ein optisches Schlierensystem und einen aktiven, Matrix-adressierbaren Flächenlichtmodulator aufweist, der eine reflektierende Oberfläche hat, deren adressierte Oberflächenbereiche einfallendes Licht beugen und deren nicht-adressierte Oberflächenbereiche einfallendes Licht reflektieren, wobei das Schlierensystem ein flächenlichtmodulatorseitiges Schlierenobjektiv, ein dem Flächenlichtmodulator abgewandtes Projektionsobjektiv und eine zwischen diesen Objektiven angeordnete Spiegelvorrichtung aufweist, die Licht von der Lichtquelle auf die Oberfläche des Flächenlichtmodulators richtet, wobei das Schlierenobjektiv mit einem bezogen auf seine Brennweite geringen Abstand zu dem Flächenlichtmodulator angeordnet ist und wobei eine Filtervorrichtung zwischen dem Schlierenobjektiv und dem Projektionsobjektiv angeordnet ist, die derart ausgebildet ist, daß sie das von den adressierten Oberflächenbereichen des Flächenlichtmodulators reflektierte, gebeugte Licht herausfiltert und das von den nicht-adressierten Oberflächenbereichen reflektierte, ungebeugte Licht über das Projektionsobjektiv zu der Vorlage oder dem elektronischen Element oder der Struktur hindurchläßt, wobei die Belichtungsvorrichtung ferner einen verfahrbaren Positioniertisch aufweist, auf dem die Vorlage oder das elektronische Element oder die Struktur derart festlegbar ist, daß die nicht adressierten Oberflächenbereiche des Flächenlichtmodulators auf der Vorlage oder dem elektronischen Element oder der Struktur scharf abbildbar sind, und wobei der Flächenlichtmodulator derart adressiert wird, daß dessen nicht-adressierte Oberflächenbereiche den zu belichtenden Projektionsbereichen der Vorlage oder des elektronischen Elementes oder der Struktur entsprechen. Bei der erfindungsgemäßen Belichtungsvorrichtung ist die Filtervorrichtung also derart ausgebildet, daß sie lediglich Licht der nullten Beugungsordnung hindurchläßt, wobei der Flächenlichtmodulator derart adressiert wird, daß dessen nicht-adressierte Oberflächenbereiche den zu belichtenden Projektionsbereichen entsprechen. Kurz gesagt arbeitet die erfindungsgemäße Belichtungsvorrichtung in dem negativen Mode. Im Gegensatz zu der in dem positiven Mode arbeitenden, oben geschilderten Belichtungsvorrichtung, bei der die Projektion eine Feinstruktur zeigt, hat die Ausleuchtung der Bildelemente bei der erfindungsgemäßen Belichtungsvorrichtung keine Feinstruktur, sondern eine ideale Homogenität mit ideal-rechteckförmiger Intensitätsverteilung. Neben der homogenen Ausleuchtung der projizierten Bildelemente gelangt unabhängig von der erzielbaren Beugungsefficiency ein hoher Intensitätsanteil der Lichtquelle zur Abbildung. Ferner wird unerwünschtes Streulicht gut unterdrückt, da der innerhalb der erfindungsgemäßen Belichtungsvorrichtung durch eine Blende ausgesperrte Bereich gegenüber dem durchgelassenen Bereich bei weitem überwiegt.

Ferner treten bei der erfindungsgemäßen Belichtungsvorrichtung auch keine Stabilitätsprobleme zur Sicherstellung einer bestimmten Mindestintensität für die Projektion auf, da die Belichtung in dem nicht-angesteuerten Zustand des betreffenden Oberflächenbereichs erfolgt, so daß im Falle eines Flächenlichtmodulators mit einer viskoelastischen Steuerschicht, auf der die reflektierende Oberfläche angeordnet ist, sich das Elastomer in seinem relaxierten Zustand befindet.

Weiterbildungen der Erfindung sind in den Unteransprüchen angegeben.

Gemäß einem wesentlichen Erfindungsaspekt handelt es sich bei der Lichtquelle der erfindungsgemäßen Belichtungsvorrichtung um eine gepulste Laserlichtquelle, deren Pulsdauer kürzer ist als der Quotient der minimalen Abmessung der zu erzeugenden Struktur geteilt durch die Verfahrgeschwindigkeit des Positioniertisches. Bei dieser Ausgestaltung ermöglicht die erfindungsgemäße Belichtungsvorrichtung ein stroboskopartiges Belichten der Vorlage bzw. des elektronischen Elementes bzw. der Struktur während eines im wesentlichen kontinuierlichen Verfahrens des Positioniertisches, wodurch sehr hohe Schreibgeschwindigkeiten oder Belichtungsgeschwindigkeiten erzielt werden.

Trotz der hohen Belichtungsintensität der einzelnen Laserlichtpulse macht die Erfindung von einem Flächenlichtmodulator Gebrauch, wie er im Stand der Technik nur für Anwendungsfälle von sehr niedriger Belichtungsintensität herangezogen wird, wie dies beispielsweise bei Fernsehbildschirmen der Fall ist. Da jedoch die Laserlichtpulse bei der erfindungsgemäßen Belichtungsvorrichtung von nur niedriger Dauer sind, bleibt der Flächenlichtmodulator den thermischen Anforderungen gewachsen. Durch die schnelle Programmierbarkeit oder Adressierbarkeit des Flächenlichtmodulators kann dieser während der Verfahrbewegung des Positioniertisches zwischen zwei aufeinanderfolgenden Teilbildern einer zu erzeugenden Gesamtstruktur umprogrammiert oder umadressiert werden. Damit ist nicht nur im Falle der Direktbelichtung von Halbleiterscheiben mit wiederholten Strukturen eine kurze Belichtungspulsfolge möglich, sondern ebenfalls aufgrund der schnellen Umprogrammierbarkeit des Flächenlichtmodulators die Erzeugung von unregelmäßigen Strukturen möglich.

Weiterbildungen der erfindungsgemäßen Belichtungsvorrichtung sind in den Unteransprüchen angegeben.

Nachfolgend wird unter Bezugnahme auf die beiliegenden Zeichnungen eine bevorzugte Ausführungsform der erfindungsgemäßen Belichtungsvorrichtung näher erläutert. Es zeigen:

| | |
|---|---|
| Fig. 1 | eine schematische Darstellung der Gesamtstruktur der erfindungsgemäßen Belichtungsvorrichtung; |
| Fig. 2 bis Fig. 4 | Detaildarstellungen einer ersten, zweiten und dritten Ausführungsform der erfindungsgemäßen Belichtungsvorrichtung; |
| Fig. 5 | einen Prismenaufsatz für die Anpassung der Lichteinlenkung bei der Ausführungsform gemäß Fig. 4; |
| Fig. 6 | eine Anpassung des Lichteinlenkwinkels bei der Ausführungsform gemäß Fig. 4 durch gedrehte Spiegelanordnung; und |
| Fig. 7 | eine vierte Ausführungsform der erfindungsgemäßen Belichtungsvorrichtung. |

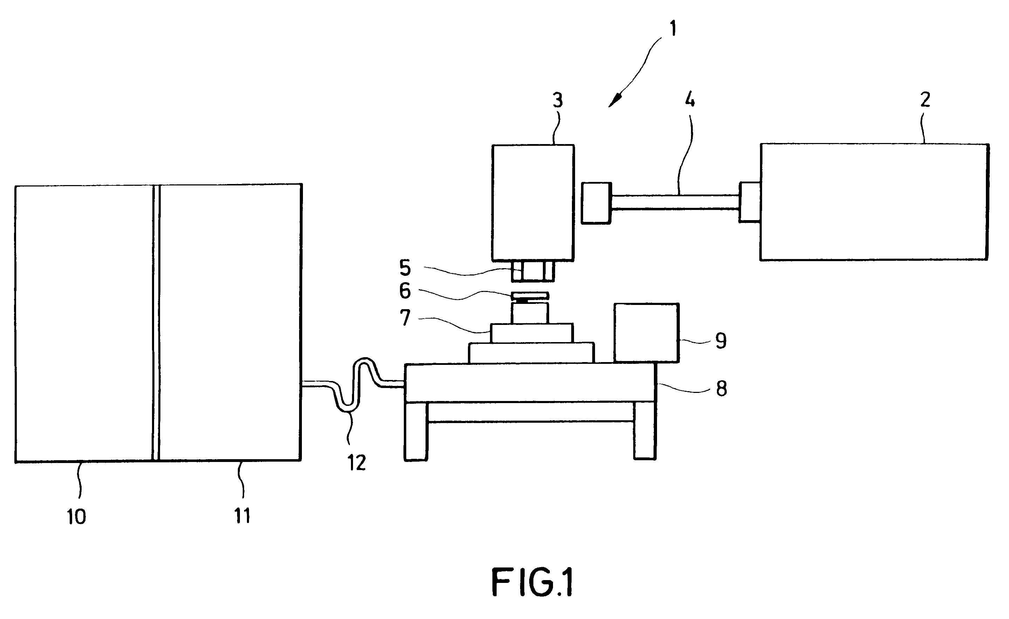

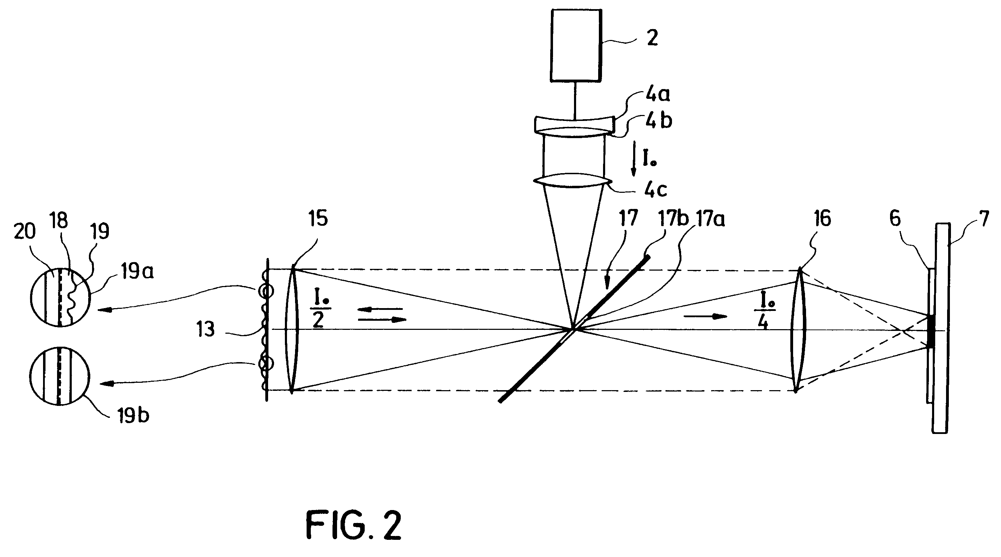

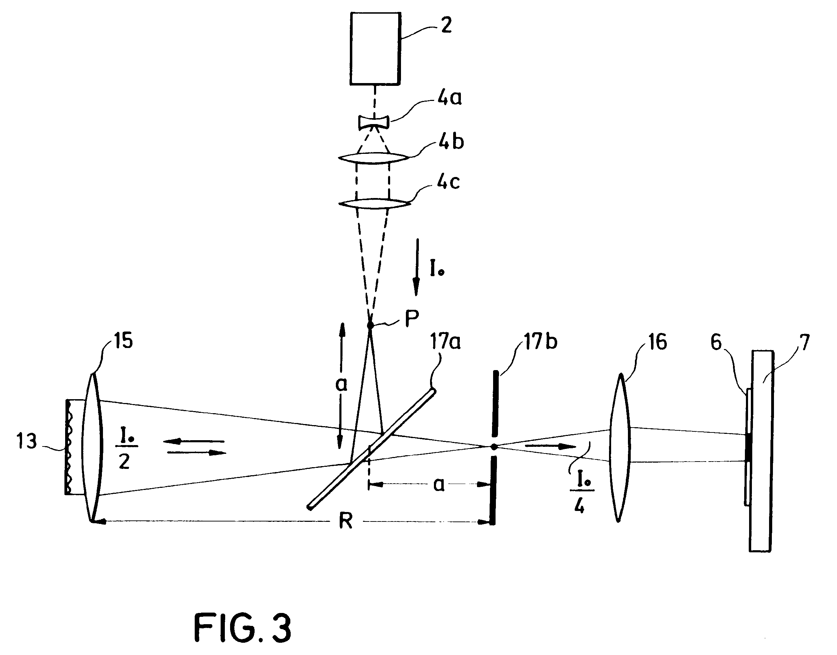

Die in Fig. 1 gezeigte Belichtungsvorrichtung ist in ihrer Gesamtheit mit den Bezugszeichen "1" bezeichnet und dient zum Herstellen von Vorlagen, wie beispielsweise Retikels und Masken für die Fertigung elektronischer Elemente, oder zum Direktbelichten von Substraten oder von Strukturen mit lichtempfindlichen Schichten. Die erfindungsgemäße Belichtungsvorrichtung 1 weist eine Excimer-Laserlichtquelle 2 auf. Diese Excimer-Laserlichtquelle ist eine Gasentladungslaservorrichtung mit Wellenlängen im UV-Bereich von etwa 450 bis 150 nm, die in steuerbarer Weise Lichtpulse mit sehr hoher Lichtintensität pro Puls und hoher Wiederholrate abgibt. Die Excimer-Laserlichtquelle 2 steht mit einem Mustergenerator 3 über eine beleuchtende optische Einheit 4 in Verbindung. Die beleuchtende optische Einheit 4 dient dazu, das Licht von der Excimer-Laserlichtquelle 2 einem später zu erläuternden Flächenlichtmodulator 13 des Mustergenerators 3 in der Weise zuzuführen, daß die Lichtapertur der Excimer-Laserlichtquelle 2 an die Oberfläche des Flächenlichtmodulators angepaßt wird. Bei bevorzugten Ausführungsformen, die nachfolgend unter Bezugnahme auf die Fig. 2 und 3 erläutert werden, ist die beleuchtende optische Einheit 4 durch Linsensysteme von an sich bekannter Struktur gebildet.

Der Mustergenerator bildet mittels einer projezierenden optischen Einheit 5 in noch näher zu beschreibenden Weise ein Muster auf eine Vorlage 6 ab, die von einem x-y-Θ-Positioniertisch gehalten wird.

Die projizierende optische Einheit 5 dient nicht nur zur Abbildung des von dem Mustergenerator 3 erzeugten Musters auf der Vorlage 6, sondern gleichfalls zur gewünschten Vergrösserung oder Verkleinerung bei der Abbildung und, soweit dies gewünscht ist, zur Autofokussierung der Abbildung auf der Vorlage 6.

Wie bereits erläutert, kann es sich bei der Vorlage beispielsweise um Retikels oder Masken handeln. Im Falle der Direktbelichtung, die gleichfalls eingangs erläutert wurde, trägt der x-y-Θ-Positioniertisch 7 anstelle der Vorlage 6 eine zu belichtende Halbleiterscheibe, ein sonstiges, mittels Photolithographie zu erzeugendes Element oder eine Struktur mit einer lichtempfindlichen Schicht, die zu beschriften oder zu belichten ist.

Der Positioniertisch 7 ist auf einer schwingungsisolierenden Trägerkonstruktion 8 angeordnet. Auf dieser Trägerkonstruktion 8 kann eine Be- und Entladestation 9 für weitere Vorlagen 6 bzw. Halbleiterelemente oder zu belichtende Strukturen vorgesehen sein. Die Be- und Entladestation 9 kann in einer in der Halbleiterfertigung üblichen Art zum automatischen Beschicken des Positioniertisches 7 mit den zu belichtenden Vorlagen oder Substraten oder sonstigen Halbleiterelementen ausgestaltet sein.

Ein Steuerrechner 10 mit zugehöriger Steuerelektronik 11 übernimmt alle Steuerfunktionen für die Belichtungsvorrichtung. Insbesondere stehen der Steuerrechner 10 und die Steuerelektronik 11 mit dem Positioniertisch 7 zum Zwecke der rechnergesteuerten Lagesteuerung des Positioniertisches in Verbindung. Der Steuerrechner 10 programmiert bzw. adressiert den Mustergenerator 3 in Abhängigkeit von der jeweiligen Steuerlage des Positioniertisches 7 zum aufeinanderfolgenden Erzeugen von Teilbildern auf der Vorlage 6, aus denen sich die belichtete Gesamtstruktur ergibt. Als Datenträger wird eine Magnetbandeinheit oder eine LAN-Schnittstelle (nicht dargestellt) eingesetzt.

Wie in Fig. 2 dargestellt ist, umfaßt der Mustergenerator 3 einen Flächenlichtmodulator oder zweidimensionalen Lichtmodulator 13 sowie ein optisches Schlierensystem, das ein dem Flächenlichtmodulator 13 zugewandtes Schlierenobjektiv 15, ein dem Flächenlichtmodulator 13 abgewandtes Projektionsobjektiv 16 und eine zwischen dem Schlierenobjektiv 15 und dem Projektionsobjektiv 16 angeordnete Spiegelvorrichtung 17 aufweist.

Das Schlierenobjektiv 15 ist mit einem bezogen auf seine Brennweite geringen Abstand zu dem Flächenlichtmodulator 13 angeordnet.

Bei der in Fig. 2 gezeigten Ausführungsform umfaßt die Spiegelvorrichtung einen um die Brennweite des Schlierenobjektives 15 von diesem beabstandeten teildurchlässigen Spiegel 17a, der um 45° gegenüber der optischen Achse der Objektive 15, 16 gedreht angeordnet ist. Der teildurchlässige Spiegel 17a erstreckt sich lediglich über einen vergleichsweise kleinen Mittenbereich, so daß von diesem lediglich das von dem Flächenlichtmodulator 13 reflektierte Licht der nullten Beugungsordnung durchgelassen wird. Außerhalb dieses Mittenbereichs ist die Spiegelvorrichtung 17 als Blende 17b ausgestaltet, welche zur Herausfilterung aller Beugungsordnungen des reflektierten Lichtes von dem Flächenlichtmodulator mit Ausnahme der nullten Beugungsordnung dient. Da nur die Hälfte der Intensität des von der Lichtquelle 2 einfallenden Lichtes durch den teildurchlässigen Spiegel 17a zu dem Flächenlichtmodulator 13 hin umgelenkt wird und da ebenfalls nur die Hälfte des von diesem reflektierten Lichtes zu dem Projektionsobjektiv 16 hin durchgelassen wird, hat das zu dem Projektionsobjektiv 16 gelangende Licht höchstens ein Viertel der Intensität des von der Lichtquelle 2 abgegebenen Lichtes.

Zwischen der Excimer-Laserlichtquelle 2 und der Spiegelvorrichtung 17 liegen eine Strahlaufweitungsoptik 4a, 4b und eine Fokussierungsoptik 4c, welche der Fokussierung des von der Excimer-Laserlichtquelle 2 abgegebenen Lichtes auf die Spiegelvorrichtung 17 dienen und welche Bestandteile der beleuchtenden optischen Einheit 4 sind.

Der Flächenlichtmodulator 13 umfaßt eine viskoelastische Steuerschicht 18, die in Richtung zu dem Schlierenobjektiv 15 von einer reflektierenden Oberfläche 19 abgeschlossen ist, welche beispielsweise von einem Metallfilm gebildet sein kann. Ferner umfaßt der Flächenlichtmodulator 13 eine sogenannte aktive Adressierungsmatrix 20, die aus einer monolithisch integrierten Anordnung von MOS-Transistoren mit zugeordneten Steuerelektrodenpaaren gebildet sein kann. Typischerweise umfaßt die Adressierungsmatrix 20 2000 x 2000 Bildelemente. Jedem Bildelement oder Oberflächenbereich 19a, 19b, ... der reflektierenden Oberfläche 19 der Adressierungsmatrix 20 sind zwei Transistoren mit ein oder mehreren Elektrodenpaaren zugeordnet, die jeweils ein Diffraktionsgitter mit einer oder mehreren Gitterperioden mit der viskoelastischen Schicht 18 und ihrer reflektierenden Oberfläche 19 bilden.

Wenn ein Oberflächenbereich 19a, 19b, ... durch Anlegen von entgegengesetzten Spannungen an den beiden Elektroden eines Elektrodenpaares des betreffenden Oberflächenbereiches adressiert wird (logisch "1"), nimmt die reflektierende Oberfläche 19 einen im Querschnitt etwa sinusförmigen Verlauf an. Bei Nicht-Adressierung ist der betreffende Oberflächenbereich 19a, 19b, ... eben. Wenn ein Lichtstrahl auf einen nicht-adressierten Oberflächenbereich 19a, 19b, ... einfällt, wird dieser reflektiert und gelangt durch den teildurchlässigen Spiegel 17a zu dem Projektionsobjektiv 16. Lichtstrahlen von adressierten Oberflächenbereichen werden durch die Blende 17b herausgefiltert.

Bei dem Ausführungsbeispiel gemäß Fig. 2 umfaßt die Spiegelvorrichtung 17 den teildurchlässigen Spiegel 17a sowie die Blende 17b, welche als Filtervorrichtung für die höheren Beugungsordnungen dient. Sowohl der teildurchlässige Spiegel 17a als auch die Blende 17b sind also im wesentlichen in der Brennebene des Schlierenobjektivs 15 angeordnet.

Bei der Ausführungsform gemäß Fig. 2 werden die Funktionen der Lichteinkopplung und der Filterung durch die Spiegelvorrichtung 17 mit einem teildurchlässigen Spiegelmittenbereich und einem blendenartigen Außenbereich realisiert. In Abweichung zu diesem Ausführungsbeispiel kann, wie nachfolgend unter Bezugnahme auf Fig. 3 erläutert wird, eine örtliche und funktionale Trennung der Lichteinkopplung und der Filterung durchgeführt werden. Die Ausführungsform gemäß Fig. 3 unterscheidet sich dadurch von der Ausführungsform gemäß Fig. 2, daß bei dieser der teildurchlässige Spiegel 17a bezüglich der Brennebene R des Schlierenobjektivs 15 entlang der optischen Achse auf das Schlierenobjektiv 15 hin versetzt angeordnet ist. Bei dieser Ausgestaltung fokussiert die Fokussiereinrichtung 4 das von der Lichtquelle 2 stammende Licht in einem Punkt P, dessen Abstand a von dem teildurchlässigen Spiegel 17a in der Achse des Strahlenganges ebenso groß ist wie der Abstand des teildurchlässigen Spiegels 17a in der optischen Achse der Optik 15, 16 von der Brennebene R des Schlierenobjektivs 15. Die funktional und örtlich nunmehr getrennt ausgebildete Blende 17b ist in der Brennebene angeordnet und dient zum Durchlassen von Licht der nullten Beugungsordnung sowie zum Herausfiltern des Lichts höherer Beugungsordnungen.

Gleichfalls ist es denkbar, bei Fokussierung des von der Lichtquelle 2 kommenden Lichts auf den teildurchlässigen Spiegel 17a in der optischen Achse den teildurchlässigen Spiegel 17a gegenüber der Brennebene des Schlierenobjektivs 15 entlang der optischen Achse auf dieses hin versetzt anzuordnen, wodurch sich die Beugungsebene entsprechend in die entgegengesetzte Richtung von der Brennebene des Schlierenobjektivs 15 wegbewegt, so daß in diesem Fall die Blende 17b gegenüber der Brennebene des Schlierenobjektivs 15 in Richtung auf das Projektionsobjektiv 16 hin versetzt anzuordnen ist.

Die Vorteile der zuletzt beschriebenen Anordnungen liegen darin, daß in diesem Fall der teildurchlässige Spiegel 17a und die Filtervorrichtung separat justiert und bezüglich ihrer Einstellung unabhängig voneinander optimiert werden können. Insbesondere können verschiedene Filter in die Belichtungsvorrichtung eingesetzt werden, ohne daß hierdurch die Justage der Lichteinkopplung berührt wird.

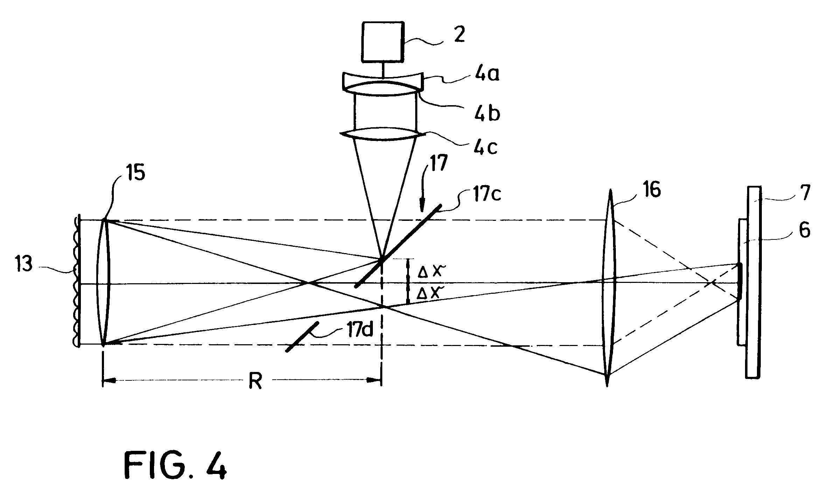

Die Ausführungsform gemäß Fig. 4 hebt sich dadurch von der Ausführungsform gemäß Fig. 2 ab, daß hier die Spiegelvorrichtung 17 durch eine verspiegelte Schlitzblende gebildet ist, welche gegenüber der optischen Achse, die durch die Objektive 15, 16 festgelegt ist, senkrecht zu dieser in Einfallsrichtung oder entgegen der Einfallsrichtung des von der Laserlichtquelle 2 stammenden Lichtes mit einem Versatz $\Delta x$ angeordnet ist. Der Schlitz 17d der Schlitzblende 17c ist derart außerhalb der optischen Achse angeordnet, daß das von den nichtadressierten Oberflächenbereichen 19a, 19b, ... des Flächenlichtmodulators 13 reflektierte Licht diesen Schlitz 17d in Richtung zum Projektionsobjektiv 16 hin durchläuft. Durch den in der Zeichnung der Fig. 4 gegenüber der optischen Achse nach oben verschobenen Spiegel der Schlitzblende 17c erhält man eine Trennung der auf der Schlitzblende gebildeten Punktlichtquelle sowie des reflektierten Lichtes der nullten Beugungsordnung.

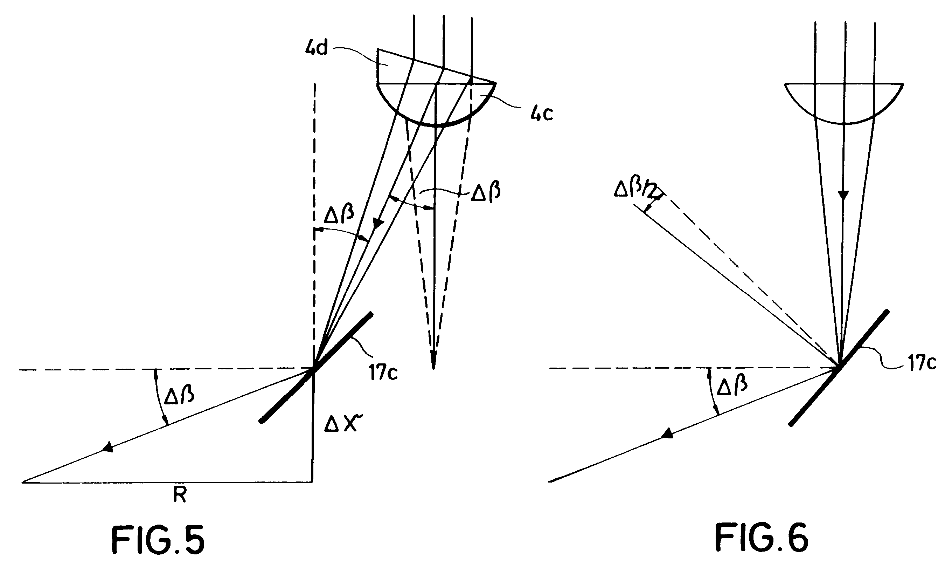

Bei dieser Ausführungsform ist zusätzlich zur Anhebung der Spiegelvorrichtung 17 eine Anpassung des Einlenkwinkels erforderlich, was durch die unter Bezugnahme auf Fig. 5 und 6 erläuterten Maßnahmen geschehen kann.

Wie in Fig. 5 gezeigt ist, kann vor der Fokussierungsoptik 4c ein Prisma 4d vorgesehen sein, welches das parallele Licht, das auf das Prisma einfällt, um einen Winkel $\Delta \beta$ ablenkt, für den folgender Zusammenhang gilt: $\Delta \beta = \arctan (\Delta x/R)$, wobei $\Delta x$ den Versatz und R die Brennweite des Schlierenobjektivs 15 bezeichnen.

In Abweichung hierzu ist es möglich, wie dies in Fig. 6 dargestellt ist, eine Anpassung des Einlenkwinkels durch Drehen des Spiegels 17c um einen Winkel $\Delta \beta/2$ vorzunehmen, für den folgender Zusammenhang gilt: $\Delta \beta/2 = 1/2 \arctan (\Delta x/R)$, wobei wiederum $\Delta x$ den Versatz und R die Brennweite des Schlierenobjektivs 15 bezeichnen.

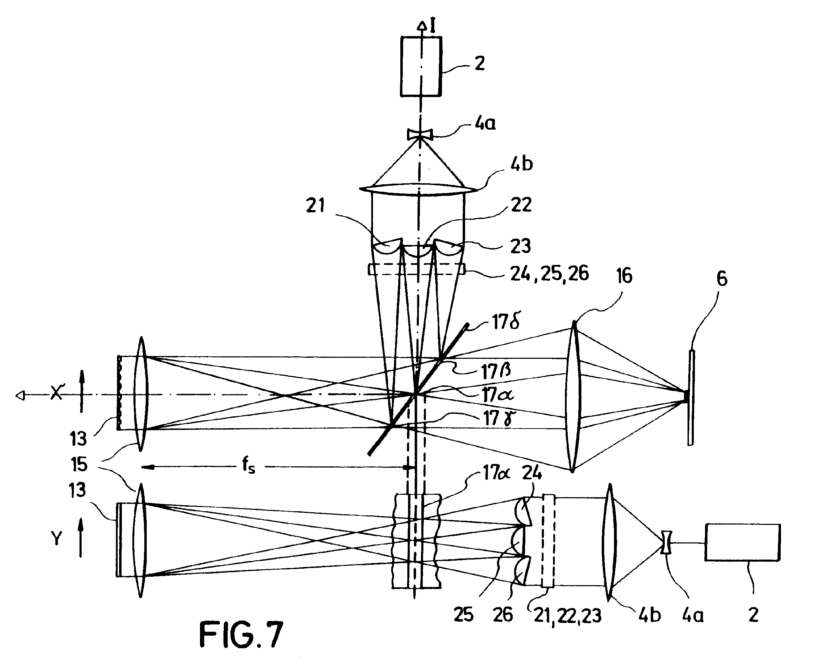

Bei der nachfolgend unter Bezugnahme auf Fig. 7 zu beschreibenden Ausführungsform wird im Gegensatz zu den vorherigen Ausführungsformen nicht nur eine einzige Punktlichtquelle erzeugt, mit der der Flächenlichtmodulator 13 beleuchtet wird, sondern mehrere, im wesentlichen punktsymmetrische Punktlichtquellen generiert, die jeweils die gesamte Fläche des Flächenlichtmodulators beleuchten. Hier umfaßt die Spiegelvorrichtung 17 drei punktsymmetrisch angeordnete, teildurchlässige Spiegel $17\alpha$, $17\beta$, $17\gamma$, die auf einer gemeinsamen Blendenstruktur $17\delta$ angeordnet sind, die zum Herausfiltern von reflektiertem Licht mit erster oder höherer Beugungsordnung dient.

Der mittlere Spiegel $17\alpha$ liegt im Brennpunkt des Schlierenobjektivs 15. Die weiteren teildurchlässigen Spiegel $17\beta$, $17\gamma$ sind zu dem erstgenannten Spiegel $17\alpha$ symmetrisch angeordnet. Die Punktlichtquelle, die am Ort des zweiten teildurchlässigen Spiegels $17\beta$ erzeugt wird, führt bei nicht-adressierten Oberflächenbereichen 19a, 19b zu einem reflektierten Lichtstrahl, der den dritten teildurchlässigen Spiegel $17\gamma$ in Richtung zum Projektionsobjektiv 16 hin durchläuft.

Die obere Darstellung gemäß Fig. 7 zeigt die Belichtungsvorrichtung in der x-z-Ebene, während die untere Darstellung die Belichtungsvorrichtung in der y-z-Ebene längs der Schnittlinie I - I der oberen Darstellung zeigt.

Die jeweiligen Achsenrichtungen der teildurchlässigen Spiegel $17\alpha$, $17\beta$, $17\gamma$, liegen in der y-Richtung und somit parallel zu der durch die Welligkeit der Oberfläche 19 des Flächenlichtmodulators 13 erzeugten Phasenstruktur.

Um die Punktlichtquellen zu erzeugen, umfaßt die beleuchtende optische Einheit 4 für jeden teildurchlässigen Spiegel 17α, 17β, 17γ, ein Zylinderlinsensystem 21, 22, 23, das parallel zu der Phasenstruktur und somit in der y-Richtung ausgerichtet ist.

Diese Zylinderlinsensysteme haben, wie aus der Fig. 7 ersichtlich ist, unterschiedliche Brennweiten zur Fokussierung auf die teildurchlässigen Spiegel 17α, 17β, 17γ. Ferner umfassen die außerhalb der optischen Achse angeordneten Zylinderlinsensysteme 21, 23 Prismen, um das Licht jeweils in einem solchen Winkel auf die Spiegel 17β, 17γ einfallen zu lassen, daß der Flächenlichtmodulator 13 jeweils ganzflächig ausgeleuchtet wird. In dem optischen Weg hinter dem parallel zu der Phasenstruktur liegenden Zylinderlinsensystem 21, 22, 23 ist ein senkrecht zu der Phasenstruktur angeordnetes Zylinderlinsensystem 24, 25, 26 vorgesehen, dessen Aufbau und Anordnung dem soeben beschriebenen Zylinderlinsensystem entspricht. Die hintereinander geschalteten Zylinderlinsensysteme erzeugen bei dem gezeigten Ausführungsbeispiel neun Punktlichtquellen auf den drei teildurchlässigen Spiegeln 17α, 17β, 17γ.

Während des Betriebes wird der Positioniertisch 7 kontinuierlich in einer vorbestimmten Bewegungsrichtung bewegt, während einander sich überlappende Teilbilder der gesamten abzubildenden Struktur auf die Vorlage 6 durch Pulsen der Excimer-Laserlichtquelle 2 abgebildet werden. In der Regel umfaßt die Adressierungsmatrix 20 eine Mehrzahl von funktionsunfähigen Bildelementen aufgrund von Herstellungsfehlern, so daß betreffende Bildelemente nicht oder nicht vollständig in den logischen Zustand "1" bzw. "0" geschaltet werden können. Diese Fehler der Matrix 20 werden dadurch kompensiert, daß alle defekten Bildelemente ermittelt und derart bearbeitet werden, daß diese nicht länger Licht reflektieren. Dadurch, daß jede Struktur auf der Vorlage 6 durch einander überlappende Teilbilder erzeugt wird, ist sichergestellt, daß jeder Teil der zu belichtenden Struktur wenigstens einmal durch ein funktionsfähiges Bildelement oder durch einen funktionsfähigen Oberflächenbereich belichtet wird.

Das Erzeugen der gesamten belichteten Struktur während des kontinuierlichen Verfahrens des Positioniertisches 7 führt nicht zu Unschärfen, da die Pulsdauer der gepulsten Excimer-Laserlichtquelle 2 kürzer ist als die minimale Abmessung der zu erzeugenden Struktur geteilt durch die Verfahrgeschwindigkeit des Positioniertisches 7.

Die Datenstruktur für die Ansteuerung der Adressierungsmatrix 20 entspricht im wesentlichen der Datenstruktur für die Ansteuerung von rasterorientierten Laserstrahl- oder Elektronenstrahlgeräten nach dem Stand der Technik. Ein erheblicher Vorteil bei der Verwendung der erfindungsgemäßen Belichtungsvorrichtung besteht darin, daß die für die Übertragung großer Datenmengen notwendige Zeit durch die Unterteilung der Adressierungsmatrix 20 und durch paralleles Programmieren von Teilmatrizen von beispielsweise 16 oder 32 Streifen fast beliebig reduziert werden kann. Ein weiterer Vorteil der erfindungsgemäßen Belichtungsvorrichtung 1 mit der Adressierungsmatrix 20 liegt darin, daß zum Zwecke der Belichtung von sich wiederholenden Strukturen, wie beispielsweise von regelmäßigen Anordnungen integrierter Schaltkreise auf einer Siliziumscheibe, die Adressierungsmatrix 20 für alle identischen Strukturen nur einmal programmiert und das programmierte Bild nur einmal gespeichert werden muß.

Es ist möglich, die erfindungsgemäße Belichtungsvorrichtung 1 mit einem Autokalibrationssystem und mit einem System für die Feinjustierung der Vorlagen 6 beim Direktschreiben zu versehen. Zu diesem Zweck werden Referenzmarken auf dem Positioniertisch 7 und auf der Vorlage 6 vorgesehen und die Adressierungsmatrix 20 als programmierbare Referenzmarke benutzt. Durch eine Autokalibration können Vergrößerungsfehler der projezierenden optischen Einheit 5 und sämtliche Positionierungsfehler kompensiert werden.

**Patentansprüche**

1. Belichtungsvorrichtung zum Herstellen von Vorlagen für die Fertigung elektronischer Elemente oder zum Direktbelichten von Scheiben oder Substraten bei den für ihre Herstellung notwendigen fotolithographischen Schritten oder von Strukturen mit lichtempfindlichen Schichten, mit einer Lichtquelle (2) und einem Mustergenerator (3), bei der
   - der Mustergenerator (3) ein optisches Schlierensystem (14) und einen aktiven, Matrix-adressierbaren Flächenlichtmodulator (13) aufweist,
   - der Flächenlichtmodulator (13) eine reflektierende Oberfläche (19) aufweist, deren adressierte Oberflächenbereiche (19a, 19b, ...) einfallendes Licht gebeugt und deren nicht-adressierte Oberflächenbereiche (19a, 19b, ...) einfallendes Licht ungebeugt reflektieren,
   - das Schlierensystem (14) ein Flächenlichtmodulatorseitiges Schlierenobjektiv (15), ein dem Flächenlichtmodulator (13) abgewandtes Projektionsobjektiv (16) und eine zwischen diesen Objektiven (15, 16) angeordnete Spiegelvorrichtung (17, 17a) aufweist, die Licht von der Lichtquelle (2) auf die Oberfläche (19) des Flächenlichtmodulators (13) richtet,

- das Schlierenobjektiv (15) mit einem bezogen auf seine Brennweite geringen Abstand zu dem Flächenlichtmodulator (13) angeordnet ist,

- eine Filtervorrichtung (17, 17b) zwischen dem Schlierenobjektiv (15) und dem Projektionsobjektiv (16) angeordnet ist, die derart ausgebildet ist, daß sie das von den adressierten Oberflächenbereichen (19a, 19b, ...) des Flächenlichtmodulators (13) reflektierte, gebeugte Licht herausfiltert und das von den nicht-adressierten Oberflächenbereichen (19a, 19b, ...) reflektierte, ungebeugte Licht über das Projektionsobjektiv (16) zu der Vorlage (6), der Scheibe, dem Substrat oder der Struktur durchläßt,

- ein verfahrbarer Positioniertisch (7) vorgesehen ist, auf dem die Vorlage (6) oder das elektronische Element oder die Struktur derart festlegbar ist, daß die nicht-adressierten Oberflächenbereiche (19a, 19b, ...) des Flächenlichtmodulators (13) auf der Vorlage (6), der Scheibe, dem Substrat oder der Struktur scharf abbildbar sind, und

- der Flächenlichtmodulator (13) derart adressiert wird, daß dessen nicht-adressierte Oberflächenbereiche (19a, 19b, ...) den zu belichtenden Projektionsbereichen der Vorlage (6), der Scheibe, dem Substrat oder der Struktur entsprechen.

2.  Belichtungsvorrichtung nach Anspruch 1, bei der
    - die Lichtquelle eine gepulste Laserlichtquelle (2) ist,
    - eine Vorrichtung zum Ansteuern der gepulsten Laserlichtquelle (2) enthalten ist, die derart ausgebildet ist, daß deren Pulsdauer kürzer als die minimale Strukturabmessung der zu erzeugenden Vorlage, der Scheibe, des Substrats oder der Struktur geteilt durch die Verfahrgeschwindigkeit des Positioniertisches (7) ist, und
    - die Vorlage (6), die Scheibe, das Substrats oder die Struktur während des Verfahrens des Positioniertisches aus einer Mehrzahl von Teilbildern durch entsprechende Adressierung des Flächenlichtmodulators (13) zusammengesetzt wird.

3.  Belichtungsvorrichtung nach Anspruch 1 oder 2, bei der
    - eine Fokussiereinrichtung (4) zum Fokussieren des Lichtes von der Lichtquelle (2) auf die Spiegelvorrichtung (17, 17a) vorgesehen ist.

4.  Belichtungsvorrichtung nach Anspruch 1 oder 2, bei der
    - eine Fokussiereinrichtung (4) zum Fokussieren des Lichtes von der Lichtquelle (2) auf einen Punkt im Strahlengang vor der Spiegelvorrichtung (17, 17a) vorgesehen ist, dessen Abstand von der Spiegelvorrichtung (17, 17a) gleich dem Abstand der Brennebene des Schlierenobjektivs (15) von der Spiegelvorrichtung (17, 17a) ist.

5.  Belichtungsvorrichtung nach einem der Ansprüche 1 bis 4, bei der
    - die Spiegelvorrichtung (17, 17a) einen um die Brennweite des Schlierenobjektivs (15) von dem Schlierenobjektiv beabstandeten teildurchlässigen Spiegel (17a) aufweist, dessen außerhalb eines Mittenbereichs liegenden Bereiche zum Erzeugen der Filtervorrichtung für das von den adressierten Oberflächenbereichen (19a, 19b, ...) reflektierte, gebeugte Licht als Blende (17b) ausgebildet sind, und
    - der teildurchlässige Spiegel (17a) auf der durch die Objektive (15, 16) festgelegten optischen Achse liegt und gegenüber dieser in einem 45°-Winkel angeordnet ist.

6.  Belichtungsvorrichtung nach einem der Ansprüche 1 bis 4, bei der
    - die Spiegelvorrichtung und die Filtervorrichtung durch eine verspiegelte Schlitzblende (17c) gebildet sind, die gegenüber der durch die Objektive (15, 16) festgelegten optischen Achse senkrecht zu dieser in Einfallsrichtung oder entgegen zu der Einfallsrichtung des von der Lichtquelle (2) stammenden Lichts mit einem Versatz $\Delta x$ angeordnet ist, und
    - der Schlitz (17d) der Schlitzblende (17c) derart außerhalb der optischen Achse angeordnet ist, daß das von den nicht-adressierten Oberflächenbereichen (19a, 19b, ...,) des Flächenlichtmodulators (13) reflektierte Licht den Schlitz (17d) durchläuft.

7.  Belichtungsvorrichtung nach Anspruch 6, bei der
    - die Schlitzblende (17c) gegenüber dem 45°-Winkel zu der optischen Achse um einen Drehwirtkel $\alpha$ verschwenkt ist, für den folgender Zusammenhang gilt:

$$\alpha \ = \ \Delta\beta/2 \ = \ 1/2 \ \text{arctg} \ (\Delta x/R),$$

wobei $\alpha$ den Drehwinkel, $\Delta x$ den Versatz und R die Brennweite des Schlierenobjektivs (15) bezeichnen.

8.  Belichtungsvorrichtung nach Anspruch 6, bei der
    - die Schlitzblende (17c) in einem 45°-Winkel zu der optischen Achse angeordnet ist, und
    - das von der Lichtquelle (2) kommende Licht im Strahlengang vor der Schlitzblende (17c) durch ein Prisma (4d) um einen Winkel $\Delta\beta$ abgelenkt wird, für den folgende Beziehung gilt:
    $$\Delta\beta \ = \ \text{arctg} \ (\Delta x/R),$$
    wobei $\Delta x$ den Versatz und R die Brennweite des Schlierenobjektivs (15) bezeichnen.

9.  Belichtungsvorrichtung nach Anspruch 2, bei der
    - die gepulste Laserlichtquelle eine Excimer-Laserlichtquelle (2) ist.

10.  Belichtungsvorrichtung nach einem der Ansprüche 1 bis 9, bei der
    - als funktionsunfähig erkannte Oberflächenbereiche (19a, 19b, ...) des Flächenlichtmodulators (13) derart behandelt sind, daß diese nicht mehr reflektieren, und
    - eine Vorrichtung zum derartigen Ansteuern des Flächenlichtmodulators (13) und des Positioniertisches (7), daß jedes Bildelement der zu belichtenden Vorlage oder des Elementes oder der Struktur wenigstens zweifach bei einander teilweise überlappenden Abbildungen in der Weise belichtet wird, daß der Versatz des abgebildeten Bildelementes mit dem Verfahrweg des Positioniertisches zwischen den Pulsen zum Erzeugen der Abbildungen übereinstimmt , enthalten ist.

11.  Belichtungsvorrichtung nach einem der Ansprüche 1 bis 10, bei der
    - jedem Oberflächenbereich (19a, 19b, ...) des Flächenlichtmodulators (13) zwei Transistoren mit jeweils einem Steuerelektrodenpaar oder mehreren Steuerelektrodenpaaren zugeordnet sind, die bei Adressierung des betreffenden Oberflächenbereiches (19a, 19b, ...) je ein oder mehrere Diffraktionsgitter mit der reflektierenden Oberfläche (19) und der von ihr überdeckten viskoelastischen Steuerschicht (18) erzeugen.

12.  Belichtungsvorrichtung nach einem der Ansprüche 1 bis 11, mit
    - einer automatischen Belade- und Entladevorrichtung für Scheiben oder Substrate, die eine vollautomatische Belichtung eines Loses von Scheiben oder Substraten gestattet.

13.  Belichtungsvorrichtung nach einem der Ansprüche 1 bis 12, mit
    - einer Vorjustiereinrichtung und einer Feinjustiereinrichtung, die das paßgenaue wiederholte Belichten der Substrate während des Fertigungsprozesses gestattet.

14.  Belichtungsvorrichtung nach Anspruch 13, bei der
    - der Flächenlichtmodulator (13) als programmierbare Referenzmarke bei der Vor- und Feinjustierung benutzt wird.

15.  Belichtungsvorrichtung nach einem der Ansprüche 1 bis 14, bei der
    - der Flächenlichtmodulator (13) eine viskoelastische Steuerschicht (18) aufweist, auf der die reflektierende Oberfläche (19) angeordnet ist.

16.  Belichtungsvorrichtung nach Anspruch 15, bei der
    - die reflektierende Oberfläche des Flächenlichtmodulators (13) mit einer Flüssigkristallschicht bedeckt ist, und
    - die elektrisch adressierbaren Oberflächenbereiche (19a, 19b, ...) eine Phasenverschiebung und damit eine Beugung des einfallenden Lichtes bewirken.

17.  Belichtungsvorrichtung nach einem der Ansprüche 1 bis 16, bei der
    - der Flächenlichtmodulator (13) eine aus adressierbaren, mechanischen Elementen bestehende reflektierende Oberfläche aufweist, deren Verbiegung eine Phasenverschiebung und damit eine Beugung des Lichtes bewirkt.

## Claims

1.  Illumination device for producing models used for manufacturing electronic elements, or for direct illumination of wafers or substrates during the photolithographic steps required for their production, or for direct illumination of structures including light-sensitive layers, comprising a light source (2) and a pattern generator (3), wherein

    - the pattern generator (3) includes an optical schlieren system (14) and an active, matrix-addressable surface light modulator (13),
    - the surface light modulator (13) has a reflective surface (19) whose addressed surface areas (19a, 19b, ...) reflect incident light as diffracted light and whose non-addressed surface areas (19a, 19b, ...) reflect incident light as undiffracted light,
    - the schlieren system (14) comprises a schlieren lens (15) arranged on the side of the surface light modulator (13), a projection lens (16) facing away from the surface light modulator (13), and a mirror device (17, 17a) which is arranged between these lenses (15, 16) and which directs light coming from the light source (2) onto the surface (19) of the surface light modulator (13),
    - the schlieren lens (15) is arranged at a distance from the surface light modulator (13) which is short relative to the focal length of said lens,
    - a filter device (17, 17b) is arranged between the schlieren lens (15) and the projection lens (16), said filter device being provided with a structural design of such a nature that it will filter out the diffracted light reflected by the addressed surface areas (19a, 19b, ...) of the surface light modulator (13) and that it will permit the undiffracted light, which is reflected by the non-addressed surface areas (19a, 19b, ...), to pass via the projection lens (16) to the model (6), to the wafer, to the substrate, or to the structure,
    - a displaceable positioning table (7) is provided on which the model (6), or the electronic element, or the structure can be secured in position in such a way that a sharp image of the non-addressed surface areas (19a, 19b, ...) of the surface light modulator (13) can be formed on the model (6), on the wafer, on the substrate, or on the structure, and
    - the surface light modulator (13) is addressed such that the non-addressed surface areas (19a, 19b, ...) thereof will correspond to the projection areas of the model (6), of the wafer, of the substrate, or of the structure which are to be illuminated.

2.  Illumination device according to claim 1, wherein

    - the light source is a pulsed laser light source (2),
    - a device for controlling said pulsed laser light source (2) is provided, said device for controlling being provided with a structural design of such a nature that its pulse duration is shorter than the minimum structural dimension of the model to be produced, or of the wafer, or of the substrate, or of the structure, divided by the displacement rate of the positioning table (7), and
    - during the displacement of the positioning table, the model (6), the wafer, the substrate, or the structure are composed of a plurality of partial images by adequate addressing of the surface light modulator (13).

3.  Illumination device according to claim 1 or 2, wherein

    - a focussing means (4) is provided, which is used for focussing the light coming from the light source (2) onto the mirror device (17, 17a).

4.  Illumination device according to claim 1 or 2, wherein

    - a focussing means (4) is provided, which is used for focussing the light coming from the light source (2) onto a point in the beam path in front of the mirror device (17, 17a) whose distance from said mirror device (17, 17a) is equal to the distance of the focal plane of the schlieren lens (15) from said mirror device (17, 17a).

5.  Illumination device according to one of the claims 1 to 4, wherein

    - the mirror device (17, 17a) comprises a semireflecting mirror (17a) arranged at a distance from the schlieren lens (15) which corresponds to the focal length of said schlieren lens (15), the areas of said semire-reflecting mirror (17a) which lie outside of a central area being constructed as a shutter (17b) so as to establish the filter device for the diffracted light reflected by the addressed surface areas (19a, 19b, ...), and
    - the semireflecting mirror (17a) is positioned on the optical axis determined by the lenses (15, 16) and is arranged such that it extends at an angle of 45° relative to said optical axis.

6. Illumination device according to one of the claims 1 to 4, wherein
 - the mirror device and the filter device are formed by a mirrored slit-type shutter (17c), which, with respect to the optical axis determined by the lenses (15, 16), is arranged at right angles to said optical axis in the incidence direction or opposite to the incidence direction of the light originating from the light source (2), with a displacement $\Delta x$, and
 - the slit (17d) of the slit-type shutter (17c) is arranged outside of the optical axis in such a way that the light reflected by the non-addressed surface areas (19a, 19b, ...) of the surface light modulator (13) will pass through said slit (17d).

7. Illumination device according to claim 6, wherein
 - the slit-type shutter (17c) is rotated relative to the 45° angle to the optical axis by an angle of rotation $\alpha$ for which the following relationship holds true:
$$\alpha = \Delta\beta/2 = 1/2 \text{ arctg } (\Delta x/R),$$
wherein $\alpha$ stands for the angle of rotation, $\Delta x$ for the displacement and R for the focal length of the schlieren lens (15).

8. Illumination device according to claim 6, wherein
 - the slit-typ shutter (17c) is arranged such that it extends at an angle of 45° relative to the optical axis, and
 - the light coming from the light source (2) is deflected in the beam path in front of the slit-type shutter (17c) with the aid of a prism (4d) by an angle $\Delta\beta$ for which the following relationship holds true:
$$\Delta\beta = \text{arctg } (\Delta x/R),$$
wherein $\Delta x$ stands for the displacement and R for the focal length of the schlieren lens (15).

9. Illumination device according to claim 2, wherein
 - the pulsed laser light source is an excimer laser light source (2).

10. Illumination device according to one of the claims 1 to 9, wherein
 - surface areas (19a, 19b, ...) of the surface light modulator (13) which have been recognized as being not in working order are treated such that they will no longer reflect, and
 - a device for controlling the surface light modulator (13) and the positioning table (7) is provided such that each pixel of the model, or of the element, or of the structure to be illuminated is illuminated at least twice with partially overlapping images in such a way that the displacement of the imaged pixel will correspond to the distance by which the positioning table has been displaced between the pulses for producing the images.

11. Illumination device according to one of the claims 1 to 10, wherein
 - each surface area (19a, 19b, ...) of the surface light modulator (13) has associated therewith two transistors each provided with one pair of control electrodes or with several pairs of control electrodes, which, in response to addressing of the respective surface area (19a, 19b, ...), will each produce one or several diffraction grating(s) with the reflective surface (19) and the viscoelastic control layer (18) covered by said reflective surface.

12. Illumination device according to one of the claims 1 to 11, comprising
 - an automatic loading and unloading device for wafers or substrates, which permits fully automatic illumination of a batch of wafers or substrates.

13. Illumination device according to one of the claims 1 to 12, comprising
 - a preadjustment means and a fine adjustment means permitting accurate, repeated illuminations of the substrates during the production process.

14. Illumination device according to claim 13, wherein
 - the surface light modulator (13) is used as a programmable reference mark during preadjustment and fine adjustment.

15. Illumination device according to one of the claims 1 to 14, wherein
 - the surface light modulator (13) is provided with a viscoelastic control layer (18) having arranged

11

thereon the reflective surface (19).

16. Illumination device according to claim 15, wherein
    - the reflective surface of the surface light modulator (13) is covered with a liquid-crystal layer, and
    - the electrically addressable surface areas (19a, 19b, ...) cause a phase displacement and, consequently, a diffraction of the incident light.

17. Illumination device according to one of the claims 1 to 16, wherein
    - the surface light modulator (13) is provided with a reflective surface consisting of addressable mechanical elements, and wherein bending of said elements will cause a phase displacement and, consequently, a diffraction of the light.


**Revendications**

1. Dispositif d'exposition lumineuse destiné à la réalisation de modèles pour la fabrication d'éléments électroniques, ou à l'exposition directe de plaques et substrats lors des étapes photolithographiques nécessaires à leur réalisation, ou de structures à couches photosensibles, avec une source de lumière (2) et un générateur de motifs (3), dans lequel
    - le générateur de motifs (3) présente un système optique strioscopique (14) et un modulateur de lumière de surface (13) à adressage matriciel actif,
    - le modulateur de lumière de surface (13) présente une surface réfléchissante (19) dont les zones de surface adressées (19a, 19b, ...) réfléchissent diffractée la lumière incidente et dont les zones de surface non-adressées (19a, 19b, ...) réfléchissent non-diffractée la lumière incidente,
    - le système strioscopique (14) présente un objectif strioscopique (15) du côté du modulateur de lumière de surface, un objectif de projection (16) du côté opposé au modulateur de lumière de surface (13) et un dispositif de miroir (17,17a), disposé entre ces objectifs (15,16), qui dirige la lumière de la source de lumière (2) vers la surface (19) du modulateur de lumière de surface (13),
    - l'objectif strioscopique (15) est disposé à une faible distance du modulateur de lumière de surface (13), par rapport à sa distance focale,
    - entre l'objectif strioscopique (15) et l'objectif de projection (16) est disposé un dispositif de filtration (17,17b) qui se présente de telle manière qu'il filtre la lumière diffractée réfléchie par les zones de surface adressées (19a, 19b, ...) du modulateur de lumière de surface (13) et qu'il laisse passer la lumière non-diffractée réfléchie par les zones de surface non-adressées (19a, 19b, ...), par l'objectif de projection (16), vers le modèle (6), la plaque, le substrat ou la structure,
    - est prévu un plateau de positionnement (7) mobile, sur lequel peut être fixé le modèle (6) ou l'élément électronique ou la structure de telle manière que les zones de surface non-adressées (19a, 19b, ...) du modulateur de lumière de surface (13) peuvent être reproduites nettement sur le modèle (6), la plaque, le substrat ou la structure, et
    - le modulateur de lumière de surface (13) est adressé de telle manière que ses zones de surface non-adressées (19a, 19b, ...) correspondent aux zones de projection à exposer du modèle (6), de la plaque, du substrat ou de la structure.

2. Dispositif d'exposition lumineuse suivant la revendication 1, dans lequel
    - la source de lumière est une source de lumière laser pulsée (2),
    - est compris un dispositif pour la commande de la source de lumière laser pulsée (2) qui se présente de telle manière que sa durée d'impulsion est plus courte que la dimension de structure minimale du modèle, de la plaque, du substrat ou de la structure à générer divisée par la vitesse de déplacement du plateau de positionnement (7), et
    - le modèle (6), la plaque, le substrat ou la structure est composé(e), pendant le déplacement du plateau de positionnement, d'une pluralité d'images partielles, par l'adressage correspondant du modulateur de lumière de surface (13).

3. Dispositif d'exposition lumineuse suivant la revendication 1 ou 2, dans lequel est prévu un dispositif de focalisation (4) destiné à focaliser la lumière de la source de lumière (2) sur le dispositif de miroir (17, 17a).

4. Dispositif d'exposition lumineuse suivant la revendication 1 ou 2, dans lequel est prévu un dispositif de focalisation (4) destiné à focaliser la lumière de la source de lumière (2) sur un point sur la trajectoire du rayon avant le dispositif de miroir (17, 17a) dont la distance par rapport au dispositif de miroir (17, 17a) est égale à la distance du plan focal de l'objectif strioscopique (15) par rapport au dispositif de miroir (17, 17a).

5. Dispositif d'exposition lumineuse suivant l'une des revendications 1 à 4, dans lequel
   - le dispositif de miroir (17, 17a) présente un miroir (17a) partiellement translucide, distant de l'objectif strioscopique de la distance focale de l'objectif strioscopique (17a), dont les zones situées en dehors d'une zone centrale se présentent, pour la production du dispositif de filtration de la lumière diffractée réfléchie par les zones de surface adressées (19a, 19b, ...), sous forme de diaphragme (17b), et
   - le miroir (17a) partiellement translucide se situe sur l'axe optique déterminé par les objectifs (15, 16) et est disposé, par rapport à celui-ci, selon un angle de 45°.

6. Dispositif d'exposition lumineuse suivant l'une des revendications 1 à 4, dans lequel
   - le dispositif de miroir et le dispositif de filtration sont formés par un diaphragme à fente à miroir (17c) qui est disposé avec un décalage $\Delta x$, par rapport à l'axe optique déterminé par les objectifs (15, 16), perpendiculairement à celui-ci dans le sens d'incidence ou contrairement au sens d'incidence de la lumière provenant de la source de lumière (2), et
   - la fente (17d) du diaphragme à fente (17c) est disposée en dehors de l'axe optique de telle manière que la lumière réfléchie par les zones de surface non-adressées (19a, 19b, ...) du modulateur de lumière de surface (13) traverse la fente (17d).

7. Dispositif d'exposition lumineuse suivant la revendication 6, dans lequel le diaphragme à fente (17c) est pivoté, par rapport à l'angle de 45° par rapport à l'axe optique, d'un angle $\alpha$, pour lequel vaut le rapport suivant:
$$\alpha = \Delta\beta/2 = 1/2 \ arctg \ (\Delta x/R),$$
$\alpha$ désignant l'angle de rotation, $\Delta x$ le décalage et R la distance focale de l'objectif strioscopique (15).

8. Dispositif d'exposition lumineuse suivant la revendication 6, dans lequel
   - le diaphragme à fente (17c) est disposé suivant un angle de 45° par rapport à l'axe optique, et
   - la lumière venant de la source de lumière (2) est déviée par un prisme (4d), dans la trajectoire de rayon avant le diaphragme à fente (17c), d'un angle $\Delta\beta$, pour lequel vaut le rapport suivant:
$$\Delta\beta = arctg \ (\Delta x/R),$$
$\Delta x$ désignant le décalage et R la distance focale de l'objectif strioscopique (15).

9. Dispositif d'exposition lumineuse suivant la revendication 2, dans lequel la source de lumière laser pulsée est une source de lumière laser à excimer (2).

10. Dispositif d'exposition lumineuse suivant l'une des revendications 1 à 9, dans lequel
    - les zones de surfaces (19a, 19b, ...) reconnues fonctionnelles du modulateur de lumière de surface (13) sont traitées de telle manière qu'elles ne réfléchissent plus, et
    - est compris un dispositif pour commander le modulateur de lumière de surface (13) et le plateau de positionnement (7) de telle manière que chaque élément d'image du modèle ou de l'élément ou de la structure à exposer est exposé au moins deux fois, lors de reproductions se recouvrant partiellement, de telle manière que le décalage de l'élément d'image reproduit corresponde au trajet de déplacement du plateau de positionnement entre les impulsions pour la génération des reproductions.

11. Dispositif d'exposition lumineuse suivant l'une des revendications 1 à 10, dans lequel à chaque zone de surfaces (19a, 19b, ...) du modulateur de lumière de surface (13) sont associés deux transistors avec, chacun, une paire d'électrodes de commande ou plusieurs paires d'électrodes de commande qui, lors de l'adressage de la zone de surface (19a, 19b, ...) concernée, génèrent, chacune, un ou plusieurs réseaux de diffraction avec la surface réfléchissante (19) et la couche d'excitation visco-élastique (18) qu'elle recouvre.

12. Dispositif d'exposition lumineuse suivant l'une des revendications 1 à 11, avec un dispositif de chargement et déchargement automatique pour plaques ou substrats qui permet une exposition lumineuse entièrement automatique d'un lot de plaques ou substrats.

13. Dispositif d'exposition lumineuse suivant l'une des revendications 1 à 12, avec un dispositif de préréglage et un dispositif de réglage fin qui permettent l'exposition lumineuse répétée avec précision des substrats au cours du processus de fabrication.

14. Dispositif d'exposition lumineuse suivant la revendication 13, dans lequel le modulateur de lumière de surface (13) est utilisé comme repère programmable lors du préréglage et du réglage fin.

15. Dispositif d'exposition lumineuse suivant l'une des revendications 1 à 14, dans lequel le modulateur de lumière de surface (13) présente une couche d'excitation visco-élastique (18) sur laquelle est disposée la surface réfléchissante (19).

16. Dispositif d'exposition lumineuse suivant la revendication 15, dans lequel
    - la surface réfléchissante du modulateur de lumière de surface (13) est recouverte d'une couche de cristal liquide, et
    - les zones de surface (19a, 19b, ...) adressables électriquement provoquent un déphasage et, de ce fait, une diffraction de la lumière incidente.

17. Dispositif d'exposition lumineuse suivant l'une des revendications 1 à 16, dans lequel le modulateur de lumière de surface (13) présente une surface réfléchissante composée d'éléments mécaniques adressables dont la déformation provoque un déphasage et, de ce fait, une diffraction de la lumière incidente.

FIG.1

FIG. 2

FIG. 3

EP 0 610 184 B1

FIG. 4

FIG.6

FIG.5

FIG.7

EP 0 610 184 B1